# EUROPÄISCHE PATENTSCHRIFT

(11) **EP 3 966 841 B1**
(45) Veröffentlichungstag und Bekanntmachung des Hinweises auf die Patenterteilung: **21.06.2023**
(21) Anmeldenummer: 20725518.3
(22) Anmeldetag: 11.05.2020
(51) Int. Cl.: H01H 13/85, H03K 17/96, H03K 17/965, B60K 37/06, G06F 3/01

(54) **BEDIENEINHEIT FÜR EIN FAHRZEUG**
OPERATING UNIT FOR A VEHICLE
UNITÉ DE COMMANDE POUR UN VÉHICULE

(30) Priorität: 09.05.2019 DE 102019112160
(43) Veröffentlichungstag der Anmeldung: 16.03.2022
(73) Patentinhaber: Behr-Hella Thermocontrol GmbH, 59557 Lippstadt (DE)
(72) Erfinder: STALLEIN, Matthias, 33397 Rietberg (DE); FUST, Winfried, 59558 Lippstadt (DE); BANDLOW, Bastian, 33100 Paderborn (DE)
(74) Vertreter: dompatent von Kreisler Selting Werner - Partnerschaft von Patent- und Rechtsanwälten mbB
(86) Internationale Anmeldenummer: PCT/EP2020/063065
(87) Internationale Veröffentlichungsnummer: WO 2020/234025

(56) Entgegenhaltungen:
- DE-A1-102011 089 400
- DE-B3-102014 019 041

## Beschreibung

Die Erfindung betrifft eine Bedieneinheit für ein Fahrzeug und insbesondere eine Bedieneinheit für ein Fahrzeug mit passivem Haptik-Konzept.

Bedieneinheiten für Fahrzeuge, bei denen das Bedienelement als Display ausgebildet ist, dessen Bedienoberfläche mit verschiedenen Symbolfeldern für die Befehlseingabe versehen ist, erfreuen sich zunehmender Beliebtheit. Dabei ist man bestrebt, dem Bediener beim Berühren eines Symbolfeldes bzw. beim Drücken gegen das Bedienelement die Haptik zu vermitteln, die der Benutzer vom Niederdrücken von Bedientasten und den hinter diesen Bedientasten angeordneten mechanischen Schaltern her kennt.

Hierzu existieren zwei grundsätzlich verschiedene Ansätze, und zwar einmal das aktive Haptik-Konzept und zum anderen das passive Haptik-Konzept. Beim aktiven Haptik-Konzept wird mangels eines mechanischen Schalters (eine valide Betätigung des Bedienelements wird durch Erfassen eines Niederdrückens der Bedieneinheit in einem definierten Ausmaß erkannt) das taktile Empfinden des Drückens eines Tasters durch impulsartige mechanische Anregung des Bedienelements, d.h. beispielsweise des als Touchscreen ausgebildete Display mit Bedienoberfläche, simuliert. Diese Konzepte erfordern zumeist eine Ermittlung der Andrückkraft, mit der auf die Bedienoberfläche eingewirkt wird (Force Sense), um dann die impulsartige Anregung mit Erreichen einer Mindestandrückkraft zu erzeugen (Force Feedback). Wird das Display an einer Stelle außerhalb eines Signalfeldes betätigt, so kann die aktive taktile Rückmeldung durch Nicht-Ansteuerung des Aktuators unterbunden werden, was dem Bedienelement eine nicht valide Betätigung signalisiert. Diese Konzepte sind von ihrer Konstruktion her recht aufwändig und erfordern beispielsweise einen Aktuator mit entsprechender Ansteuerung.

Wesentlich einfacher lässt sich die Haptik eines gedrückten Schalters bei einem Bedienelement mit Bedienoberfläche, die mehrere Symbolfelder aufweist, dadurch realisieren, dass das Bedienelement beim Niederdrücken einen beispielsweise mechanischen Schalter betätigt. Dieser mechanische Schalter sorgt dann für das Haptik-Konzept und das Haptik-Feedback, wie es der Benutzer vom Drücken einer Bedientaste her kennt.

Problematisch bei dem passiven Haptik-Konzept mit mechanischem Schalter ist allerdings, dass der Benutzer auch dann das taktile Empfinden eines gedrückten Schalters hat, wenn er die Bedienoberfläche außerhalb eines Symbolfeldes berührt und an dieser Stelle gegen das Bedienelement drückt. In dieser Situation würde keine wirksame Befehlseingabe erfolgen; dennoch wird dem Benutzer taktil vermittelt, dass er eine Schaltfunktion o.dgl. ausgelöst hat.

Mechanisch bzw. elektromechanisch arbeitende Niederdrückkraftschwellen-Umschaltvorrichtungen , die im Grundzustand die Niederdrückbarkeit eines insbesondere als Touchscreen ausgebildeten Bedienelements mechanisch verhindern und Mechaniken aufweisen, um diese Sperrfunktion im Bedarfsfalle aufzuheben und damit die Niederdrückbarkeit des Bedienelements freizugeben, sind aus DE-B-10 2014 019 041 und DE-A-10 2010 026 910 bekannt. Diese bekannten Niederdrückkraftschwellen-Umschaltvorrichtungen haben den Nachteil, dass sie im Falle einer missbräuchlichen Betätigung des Bedienelements oder bei einer versehentlich zu hohen auf das Bedienelement einwirkenden Niederdrückkraft beschädigt oder gar zerstört werden könnten.

Aus DE-B-10 2018 212 618 ist es bekannt, statt einer mechanisch arbeitenden Niederdrückkraftschwellen-Umschaltvorrichtung einen Blockierkörper aus einem elektroaktiven Polymer zu verwenden.

Eine Bedieneinheit mit den Merkmalen des Oberbegriffs des Anspruchs 1 ist in DE-A-10 2011 089 400 beschrieben.

Aufgabe der Erfindung ist es, eine Bedieneinheit für ein Fahrzeug insbesondere mit sogenanntem passiven Haptik-Konzept hinsichtlich des Bedienkomforts zu verbessern.

Zur Lösung dieser Aufgabe wird mit der Erfindung eine Bedieneinheit für ein Fahrzeug vorgeschlagen, die versehen ist mit
- einem Gehäuse,
- einem Bedienelement mit einer Bedienoberfläche, die mehrere Symbolfelder aufweist, welchen bei Betätigung des Bedienelements auslösbare Bedienfunktionen zugeordnet sind,
- wobei das Bedienelement rückstellfähig sowie mittels eines Betätigungsobjekts, insbesondere mittels des Fingers einer Hand, niederdrückbar an einer Trägerstruktur angeordnet ist,
- einer ansteuerbaren Niederdrückkraftschwellen-Umschaltvorrichtung zum Umschalten der zum Niederdrücken des Bedienelements zu überwindenden Kraft zwischen einem ersten Schwellwert und einem im Vergleich zum ersten Schwellwert kleineren zweiten Schwellwert, und umgekehrt,
- einer Betätigungssensorik zur Erkennung, ob das Betätigungsobjekt bei einer Betätigung des Bedienelements dieses innerhalb eines der Symbolfelder der Bedienoberfläche kontaktiert, und
- einer Auswerte- und Ansteuereinheit, die von der Betätigungssensorik oder unter anderem von der Betätigungssensorik Signale empfängt und die Niederdrückkraftschwellen-Umschaltvorrichtung oder unter anderem an die Niederdrückkraftschwellen-Umschaltvorrichtung nur dann durch Veränderung ihrer Ansteuerung zum Umschalten von dem ersten Schwellwert auf den zweiten Schwellwert veranlasst, wenn sich bei einer Betätigung des Bedienelements das Betätigungsobjekt innerhalb eines der Symbolfelder in Kontakt mit der Bedienoberfläche befindet,
- wobei die Niederdrückkraftschwellen-Umschaltvorrichtung mindestens einen Elektromagneten mit einem Stator und einem Anker, die relativ zueinander bewegbar sind, und eine Spule aufweist und
- wobei entweder der Anker an dem Bedienelement oder an einem mit dem Bedienelement mechanisch verbundenen Element an und/oder in dem Gehäuse montiert ist, oder entweder der Stator an dem Bedienelement oder an einem mit dem Bedienelement mechanisch verbundenen Element befestigt und der Anker an/oder in dem Gehäuse montiert ist.

Nach der Erfindung ist also sinngemäß vorgesehen, ein Bedienelement einer Bedieneinheit, das eine Bedienoberfläche mit mehreren Symbolfeldern aufweist und das beim Betätigen z. B. einen mechanischen Schalter auslöst, hinsichtlich seiner Bewegbarkeit beim Niederdrücken, also hinsichtlich seiner Niederdrückbarkeit dann ggf. mit niedriger Kraftschwelle (zweiter Schwellenwert) zu ermöglichen, wenn mittels einer Betätigungssensorik erkannt worden ist, dass sich das die Bedienoberfläche berührende Bedienobjekt innerhalb eines Symbolfeldes der Bedienoberfläche befindet. Durch eine andernfalls erfolgende Umschaltung auf eine wesentlich größere Kraftschwelle (erster Schwellenwert) werden beispielsweise Schalterauslösungen vermieden, wenn das Betätigungsobjekt in einem Bereich außerhalb eines Symbolfeldes, also beispielsweise zwischen zwei Symbolfeldern, befindet. In dieser Situation ist die Niederdrückbarkeit des Bedienelements wesentlich erschwert, die zu überwindende Niederdrückkraftschwelle ist also wesentlich höher, als im oben genannten ersten Fall.

Dieses Konzept erlaubt nicht nur die einfache Umsetzung des passiven Haptik-Konzepts bei Bedienelementen mit mehrere Symbolfelder aufweisenden Bedienoberflächen, sondern verhindert überdies ungewollte Bewegungen des Bedienelements in Folge beispielsweise auf das Fahrzeug einwirkenden Erschütterungen. Denn bei Bedieneinheiten mit haptischem Feedback ist das Bedienelement typischerweise federnd gelagert, kann also ungewollte in Schwingung geraten, was wiederum zu Schaltfunktionsauslösungen kommen kann.

Die Erfindung kann aber wesentlich allgemeiner aufgefasst werden, als zuvor beschrieben. Es geht bei der Erfindung ganz grundsätzlich um die Freigabe der Niederdrückbarkeit eines Bedienelements, und zwar gänzlich unabhängig davon, ob das Bedienelement mit haptischem Feedback ausgestattet ist oder nicht. Nach der Erfindung wird die Niederdrückkraftschwelle zunächst einmal grundsätzlich hoch eingestellt (erster Schwellenwert) und wird nur dann auf den zweiten Schwellenwert, der auch Null betragen kann, reduziert,, wenn eine valide Betätigung des Bedienelements vorliegt. Die Niederdrückkraftschwellen-Umschaltvorrichtung ist erfindungsgemäß als Elektromagnet ausgebildet, der mit oder ohne Permanent-Magnet ausgestattet sein kann. Bei einem Elektromagnet ohne Permanent-Magnet wird die Haltekraft durch Bestromung der Spule erzeugt. Diese Bestromung wird dann aufgehoben, wenn die Niederdrückbarkeit des Bedienelements freigegeben werden soll. Insoweit steuert also die Auswerte- und Ansteuereinheit der erfindungsgemäßen Bedieneinheit einen derartigen Elektromagneten mit einem ersten Ansteuersignal an, um die Haltekraft zu erzeugen, und mit einem zweiten Ansteuersignal an, um die Bestromung der Spule aufzuheben und damit die Haltekraft aufzuheben.

Von der Ansteuerung und dem Energieverbrauch günstiger ist der Einsatz eines Permanent-Elektrohaftmagneten als Niederdrückkraftschwellen-Umschaltvorrichtung. Hier sorgt das von einem Permanentmagneten erzeugte Magnetfeld für die Haltekraft, die nur für diejenigen Zeiträume aufgehoben werden muss, in denen das Bedienelement niederdrückbar sein soll. Dazu wird eine Spule entsprechend bestromt, um durch ihr Magnetfeld das Permanent-Magnetfeld zu neutralisieren. Die Nicht-Bestromung der Spule oder die Bestromung der Spule mit einem Ruhestrom, der zur Kompensation des Permanent-Magnetfeldes nicht groß genug ist, repräsentiert also ein erstes Ansteuersignal, während das zweite Ansteuersignal, das von der Auswerte- und Ansteuereinheit ausgegeben wird, der Bestromung der Spule dient bzw. zur Bestromung der Spule führt, und zwar mit dem Ziel der Kompensation (Neutralisation) des Magnetfeldes des Permanentmagnets.

In vorteilhafter Ausgestaltung der Erfindung ist also der Elektromagnet als Permanent-Elektrohaftmagnet ausgebildet, der für die Erzeugung eines Permanent-Magnetfeldes zum Festhalten des Ankers zuständig ist, wobei die Spule zur Aufrechterhaltung der hohen Niederdrückkraftschwelle kein Ansteuersignal zur Bestromung der Spule empfängt und wobei die Spule zum Freigeben der Niederdrückbarkeit des Bedienelements ein Ansteuersignal zum Bestromen der Spule zwecks Neutralisierung oder deutlicher Herabsenkung des Permanent-Magnetfeldes empfängt.

In vorteilhafter Weiterbildung der Erfindung ist beispielsweise vorgesehen, dass die Niederdrückkraftschwellen-Umschaltvorrichtung in ihrer Grundeinstellung die Niederdrückbarkeit stark erschwert und dass die Auswerte- und Ansteuereinheit dann, wenn die Betätigungssensorik signalisiert, dass das Betätigungsobjekt die Bedienoberfläche innerhalb eines der Symbolfelder kontaktiert, an die Niederdrückkraftschwellen-Umschaltvorrichtung ein Signal zur Umschaltung auf die niedrige (zweiter Schwellenwert) Niederdrückbarkeits-Kraftschwelle ausgibt.

Zweckmäßigerweise kann ferner vorgesehen sein, dass die Niederdrückkraftschwellen-Umschaltvorrichtung die Niederdrückbarkeits-Kraftschwelle auf den hohen ersten Kraftschwellenwert umschaltet bzw. beibehält, wenn die Betätigungssensorik keine Berührung eines Symbolfeldes an der Bedienoberfläche durch das Betätigungsobjekt signalisiert, oder dass die Niederdrückkraftschwellen-Umschaltvorrichtung die Niederdrückbarkeit des Bedienelements so lange auf dem hohen Schwellenwert hält, wie die Betätigungssensorik keine Berührung eines Symbolfeldes an der Bedienoberfläche durch das Betätigungsobjekt signalisiert.

Wie bereits oben erwähnt, ist das Bedienelement typischerweise als Display ausgeführt. Zweckmäßigerweise handelt es sich bei dem Display um einen Touchscreen (oder auch Touchpad). Ein derartiger Touchscreen verfügt über eine Berührungssensorik, mit der dann erkannt werden kann, welches Symbolfeld mittels des Betätigungsobjekts kontaktiert ist. Sämtliche Konzepte der Berührungssensorik, wie sie von Touchscreens oder Touchpads her bekannt sind, können bei der erfindungsgemäßen Bedieneinheit eingesetzt werden. Die auf dem Display dargestellte Information ist typischerweise veränderbar, wie es von beispielsweise menügeführten Graphikoberflächen her bekannt ist. Die Informationen können in Form von Symbolen, Graphiken, Icons oder alphanummerischen Zeichen vorliegen. Die Erfindung lässt sich aber auch bei Bedienelementen mit "feststehender" Anzeigefläche als Bedienoberfläche realisieren. Eine derartige "feststehende" Anzeigefläche zeigt stets die gleiche und damit unveränderbare Information an, was beispielsweise durch hinterleuchtete Symboliken, Icons, Graphiken oder alphanumerische Zeichen realisiert werden kann.

Die Merkmale weitere Ausgestaltungen der Erfindung sind, soweit zuvor oder im Folgenden nicht explizit erwähnt, Gegenstand von Unteransprüchen.

Die Realisierung der wahlweisen Reduzierung der Niederdrückbarkeits-Kraftschwelle des Bedienelements mittels des erfindungsgemäß vorgesehenen Elektromagneten bzw. Permanent-Elektrohaftmagneten hat den Vorteil gegenüber reinen Sperrvorrichtungen mit mechanischer Verriegelung, wie eingangs referenziert, und ist mit diesen Systemen insoweit nicht vergleichbar, als dass aus Sicherheitsgründen die Freigabe auch bei Überschreitung einer bestimmten, beispielsweise manuell aufgebrachten recht hohen Andrückkraft erfolgt, und zwar reversibel, d.h. ohne die Niederdrückkraftschwellen-Umschaltvorrichtung zu beschädigen. Die Widerstandskraft gemäß dem ersten Schwellwert, die durch das Magnetfeld infolge des Ruhestroms des Elektromagneten und/oder durch das Permanent-Magnetfeld des Permanent-Elektrohaftmagneten entsteht, wird dann überwunden, wenn recht stark gegen das Bedienelement gedrückt wird. Dies kann beispielsweise missbräuchlich oder versehentlich erfolgen, wenn nämlich von außen auf die Bedieneinheit Vibrationen oder Aufschlagkräfte einwirken. Typische in der Praxis anzutreffende Kraftschwellen, die bei der gewollten Betätigung einer Taste oder eines Bedienelements in Form eines Displays überwunden werden müssen, bewegen sich in der Größenordnung von einigen wenigen N (Newton), z. B. 2 bis 4 N, was z. B. die Größe des zweiten Schwellwerts sein kann, der aber auch 0 N betragen kann. Die Haltekraft bzw. Widerstandskraft gemäß dem ersten Schwellwert, der mittels des erfindungsgemäß verwendeten Systems bereitgestellt werden kann, kann beispielsweise ein Zehnfaches der zuvor genannten Kraftschwelle betragen, also z. B. zwischen 20 N und 50 N liegen. Wird die durch diesen ersten Schwellwert bestimmte Maximalhaltekraft überschritten, so öffnet der Elektromagnet bzw. der Permanent-Elektrohaftmagnet, d.h. so bewegt sich der Anker relativ zum Stator und damit von diesem weg. Sobald diese Maximalkraft dann nicht mehr auf das Bedienelement einwirkt, nimmt die Niederdrückkraftschwellen-Umschaltvorrichtung wieder ihre vorgesehene Funktion ein. Das wäre bei einem rein mechanisch verriegelnden System nicht gegeben.

Die hohe Kraftschwelle (erster Schwellwert) ist dafür gedacht, dem Benutzer zu signalisieren, dass er das Bedienelement aktuell nicht vorschriftsmäßig betätigt bzw. an einer "falschen Stelle" betätigt. Gewohnheitsbedingt wird ein Benutzer in einem solchen Fall zunächst mit vergleichsweise niedriger Andrückkraft versuchen, das Bedienelement niederzudrücken. Wenn das nicht funktioniert, so versucht man intuitiv die Betätigung des Bedienelements mit erhöhtem Kraftaufwand. Diesem erhöhten Kraftaufwand sollte das Bedienelement dann noch ausreichend Widerstand entgegensetzen. Das sollte auch dann gelten, wenn der Benutzer ein weiteres Mal mit dann wiederum erhöhtem Kraftaufwand versucht, das Bedienelement niederzudrücken. Die erste Kraftschwelle sollte also oberhalb all dieser für gewöhnlich zu erwartenden Betätigungskräfte liegen.

In diesem Sinne handelt es sich bei der erfindungsgemäß eingesetzten Niederdrückkraftschwellen-Umschaltvorrichtung um eine zwischen zwei Niederdrücckraftschwellen reversibel umschaltbare Vorrichtung, die also die Niederdrückbarkeit des Bedienelements in jedem Fall bei Überschreitung der zuvor genannten Maximalhaltekraft ermöglicht, und zwar reversibel, es aber auch ermöglicht, dass die Haltekraft reduziert wird, wenn das Bedienelement bei vorschriftsmäßiger Betätigung niederdrückbar sein soll. Im letztgenannten Fall ist es sogar möglich, die Kraftschwelle für die ordnungsgemäße Betätigung des Bedienelements elektrisch einzustellen, indem nämlich bei einem reinen Elektromagneten als Haftmagnet der Spulenstrom abgesenkt wird und bei einem Permanent-Elektrohaftmagnet der Spulenstrom unterhalb derjenigen Größe bleibt, bei der das Elektromagnetfeld das Permanent-Magnetfeld vollständig kompensiert.

Mit dem erfindungsgemäßen Konzept der Realisierung der Niederdrückkraftschwellen-Umschaltvorrichtung als Elektromagnet lässt sich also wesentlich mehr Funktionalität erreichen, was die Freigabefunktion betrifft, als bei einem rein mechanisch verriegelnden System, wie es bei den Systemen der eingangs zuerst genannten Druckschriften der Fall ist.

Die Erfindung wird nachfolgend anhand eines Ausführungsbeispiels und unter Bezugnahme auf die Zeichnung, in der schematisch ein Ausführungsbeispiel der Erfindung gezeigt ist, näher erläutert. Im Einzelnen zeigen dabei:
- Fig. 1: eine schematische Darstellung einer Bedieneinheit gemäß einem erfindungsgemäßen Ausführungsbeispiel und
- Fig. 2: eine schematische Darstellung eines Permanent-Elektrohaftmagnets.

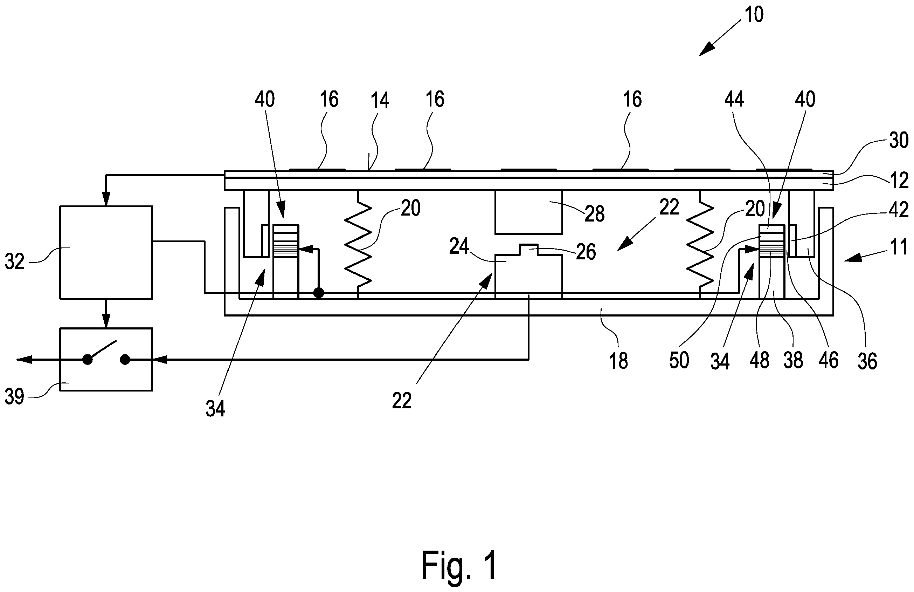

In Fig. 1 ist schematisch eine Bedieneinheit 10 mit passivem haptischen Konzept gezeigt. Die Bedieneinheit 10 weist in diesem Ausführungsbeispiel ein Gehäuse 11 mit einem als Touch-Screen ausgeführten Bedienelement 12 mit Bedienoberfläche 14 auf, wobei die Bedienoberfläche 14 mehrere Symbolfelder 16 aufweist. Das Bedienelement 12 ist an einer Trägerstruktur 18 niederdrückbar geführt und wird durch z. B. Federn 20 o.dgl. rückstellfähige Komponenten in seine Ausgangsstellung gemäß Fig. 1 vorgespannt. Auf diese Weise ist das Bedienelement 12 federelastisch gelagert.

Eine Niederdrück-Betätigung durch ein Betätigungsobjekt, beispielsweise durch den Finger einer Hand oder durch ein stiftähnliches Objekt bewirkt, dass ein beispielsweise ebenfalls an der Trägerstruktur 18 angeordneter mechanischer Schalter 22 betätigt wird. Der mechanische Schalter 22 weist beispielsweise ein Schaltergehäuse 24 mit federelastisch in seiner Ausgangsstellung gehaltenem Schaltorgan 26 auf. Auf dieses Schaltorgan 26 wirkt ein an dem Bedienelement 12 vorgesehener Stößel 28.

Der mechanische Schalter 22 verleiht dem Benutzer ein haptisches Feedback, wenn das Bedienelement 12 niedergedrückt wird. Die mechanische Charakteristik des Schalters 22 beim Niederdrücken des Bedienelements 12, d. h. beim Niederdrücken des Schaltorgans 26, wird also mechanisch auf das Bedienelement 12 übertragen und führt zu einem taktilen Empfinden beim Benutzer, das gleich demjenigen ist, dass der Benutzer beim Niederdrücken eines Tasten-Schalters verspürt. Als Schalter 22 kommt beispielsweise ein KeyTop, eine Schaltmatte mit integrierter Schnappscheibe oder aber auch ein Kurzhubtaster in Frage.

Problematisch hinsichtlich des taktilen Empfindens des Benutzers, einen Schaltvorgang ausgelöst zu haben, ist es, wenn dies auch dann erfolgt, wenn der Benutzer beim Niederdrücken des Bedienelements 12 sich nicht auf einem Symbolfeld 16, sondern beispielsweise zwischen zwei Symbolfeldern 16, also in einem Bereich auf der Bedienoberfläche 14 befindet, in dem beim Niederdrücken des Bedienelements 12 keine Schaltfunktion bzw. keine Befehlseingabe erfolgen kann. Dennoch wird ihm eine valide Befehlseingabe bzw. die Durchführung einer Schaltfunktion suggeriert, da er ein entsprechendes taktiles Empfinden verliehen bekommt.

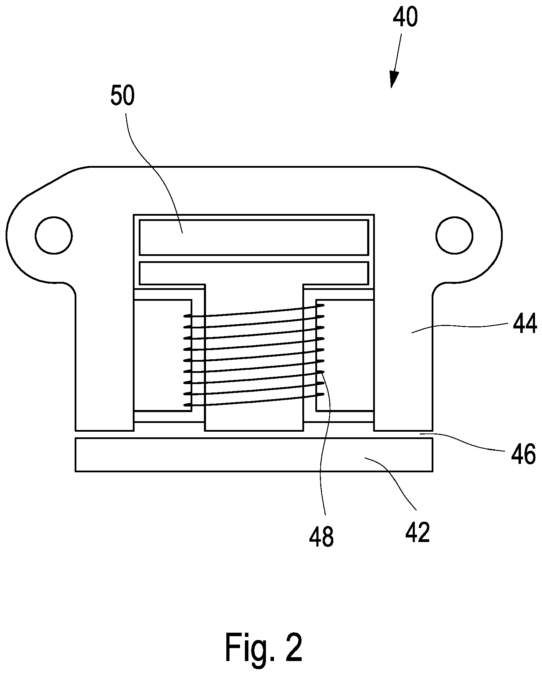

Daher ist nach der Erfindung vorgesehen, die Niederdrückbarkeit des Bedienelements 12 grundsätzlich in recht starkem Maße nur dann mit dem bei einer Bedientastenbetätigung gewohnten Kraftaufwand zuzulassen, wenn bei der Berührung der Bedienoberfläche 14 erkannt worden ist, dass sich das Betätigungsobjekt (der Finger einer Hand) auf einem Symbolfeld 16 befindet. Durch eine Betätigungssensorik 30 in Form einer wie bei Touch-Screens an sich üblich in das Display integrierten Berührungssensorik kann erkannt werden, wo sich auf der Bedienoberfläche 14 der beispielsweise Finger des Nutzers befindet. Die Betätigungssensorik 30 gibt ein entsprechendes Signal an eine Auswerte- und Ansteuereinheit 32, die eine Niederdrückkraftschwellen-Umschaltvorrichtung 34 zur Ermöglichung des Umschaltens der Kraftschwelle für die Niederdrückbewegung des Bedienelements 12 zwischen einem recht hohen und einem niedrigeren, von z.B. Null, Wert ausgibt. Bei dieser Niederdrückkraftschwellen-Umschaltvorrichtung 34 handelt es sich beispielsweise um ein oder mehrere Elektromagnete oder Permanent-Elektrohaftmagnete (siehe auch Fig. 2), die im nicht angesteuerten Zustand mittels eines integrierten Permanentmagneten verhindern, dass sich z. B. ein mit dem Bedienelement 12 verbundenes erstes Teil 36 gegenüber einem an der Trägerstruktur 18 angeordneten zweites Teil 38 verschiebt. Der magnetische Fluss des Permanentmagneten wird zur Aufhebung des durch ihn erzeugten recht großen Widerstandes bei Ansteuerung einer Spule, was durch die Auswerte- und Ansteuereinheit 32 bewirkt wird, aufgehoben, verändert oder umgelenkt, so dass nun das Bedienelement 12 bewegbar und niederdrückbar ist.

In Fig. 1 ist ferner angedeutet, dass das Bedienelement 12 an einem Symbolfeld 16 niedergedrückt wird. Die Auswerte- und Ansteuereinheit 32 erkennt dies aufgrund der von der Betätigungssensorik 30 gelieferten Positionsdaten oder aber die Betätigungssensorik 30 signalisiert nur dann eine dementsprechend valide Betätigung der Bedienoberfläche 14, wenn diese an einem Symbolfeld 16 erfolgt. In beiden Fällen steuert die Auswerte- und Ansteuereinheit 32 die Niederdrückkraftschwellen-Umschaltvorrichtung 34 zum Umschalten auf den niedrigeren zweiten Schwellwert für die Betätigung des Bedienelements 12 mit reduzierter erforderlicher Kraftschwelle oder mit einer Kraftschwelle von 0 N an. Das vom Schalter 22 gelieferte Schaltsignal wird dann ebenfalls beispielsweise von der Auswerte- und Ansteuereinheit 32 freigegeben bzw. durchgeschaltet, was in Fig. 1 bei 39 angedeutet ist.

Wie sich aus dem Vorstehenden ergibt, zeigt Fig. 1 exemplarisch die hauptsächlich miteinander zusammenwirkenden Komponenten und Elemente der Erfindung. Das Bedienelement 12 mit Bedienoberfläche 14 ist typischerweise federnd gelagert. Bei einer Krafteinwirkung von oben und bei Überschreitung der beispielsweise durch die Vorspannung des Schaltorgans 26 definierten Schaltschwelle löst der Schalter 22 aus. Der Schalter weist eine insoweit charakteristische Kraft-Weg-Kennlinie auf, als mit zunehmender Kraft das Schaltorgan bis zu einem Punkt bewegt wird, ab dem das Schaltorgan "schlagartig" in die Schalterauslöseposition gelangt, und zwar ohne, dass zusätzliche Kraft aufgewendet werden muss. Dabei wird ein mechanisches Feedback (Haptik), nämlich die Kraftrückwirkung, an die Bedienoberfläche 14 zurückgegeben. Durch wahlweises Umschalten der dem Niederdrücken des Bedienelements 12 entgegenstehenden Widerstandskraft auf den höheren ersten Schwellwert oder durch die zumindest temporäre und von definierbaren Gegebenheiten vorgebbare höhere Widerstandskraft für einzelne Symbolfelder 16 kann die Bedienoberfläche 14 bzw. das Bedienelement 12 arretiert werden, so dass ein Auslösen des Schalters 22 unterbunden werden kann.

Der Einsatz eines schematisch in Fig. 2 gezeigten Permanent-Elektrohaftmagneten 40 als Niederdrückkraftschwellen-Umschaltvorrichtung 34 ist insoweit vorteilhaft, als sich der in der Halteposition bewegbare Anker 42 und der ruhende Stator 44 des Haftmagneten nicht berühren, sondern durch einen z.B. Minimal-Luftspalt 46 voneinander getrennt bleiben. Der Spalt 46 könnte auch durch mechanisch dampfendes, d.h. z.B. komprimierbares Material ausgefüllt sein. Es kommt also nicht zu einer Geräuschentwicklung und Kontaktierung von Anker 42 und Stator 44 und damit nicht zu einer möglicherweise mechanischen Kraftrückwirkung auf die Bedienoberfläche 14, was den Komfort beeinträchtigen würde. Der ruhende Stator 44 oder aber der bewegbare Anker 42 ist mit einem Permanentmagneten 50 versehen. Der Stator 44 weist darüber hinaus eine Spule 48 auf, die von Strom durchflossen wird, um das magnetische Feld, das von einem Permanentmagneten 50 ausgeht und sich auf die Positionseinhaltung des Ankers 42 auswirkt, aufzuheben, zu verändern, umzuleiten o.dgl. Wird nämlich über die Betätigungssensorik 30, bei der es sich klassischerweise um eine Touch-Sensorik handelt, der Finger einer Hand erkannt, so wird die Spule 48 des Permanent-Elektrohaftmagneten 40 bestromt und damit die höhere Widerstandskraft aufgehoben. Dies erfolgt innerhalb weniger Millisekunden und liegt damit außerhalb der wahrnehmbaren Latenz.

Die erfindungsgemäße Konstruktion erlaubt es also auf einfache Art und Weise, komfortabel das passive Haptik-Konzept umzusetzen. Dieses ist dadurch gekennzeichnet, dass ein niederdrückbares Bedienelement auf einen mechanischen Schalter einwirkt, der einen taktil wahrnehmbare Kraftrückwirkung auf das Bedienelement hat. Das Bedienelement weist eine Vielzahl von Symbolfeldern auf. Nicht immer ist die gesamte Bedienoberfläche mit Symbolfeldern belegt. Beispielsweise können auf der Bedienoberfläche "isolierte Tast-Flächen" ausgewiesen sein. Zwischen diesen isolierten Flächen ist keine Funktion gegeben. Ohne weitere Maßnahmen kann sich die Bedienoberfläche bei Krafteinwirkung durch einen Finger aber bewegen und so eine nicht vorhandene Funktionsauslösung suggerieren. Die erfindungsgemäß einstellbare höhere Niederdrück-Widerstandskraft verhindert dies. Die erschwerte Niederdrückbarkeit aufgrund des hohen ersten Schwellwerts wird nur gelöst, wenn sich der Finger auf ausgewiesenen Touch-Flächen befindet. Auch kann dies bei ausgewiesenen Touch-Flächen lediglich temporär gelöst werden. Damit kann verhindert werden, dass aufgrund zuvor definierter Betriebszustände beispielsweise eines Fahrzeuges einer Touch-Fläche, die grundsätzlich freigeschaltet ist, die höhere Niederdrück-Widerstandskraft zugeordnet und damit "unwirksam" gemacht wird.

### BEZUGSZEICHENLISTE

- 10: Bedieneinheit
- 11: Gehäuse der Bedieneinheit
- 12: Bedienelement
- 14: Bedienoberfläche des Bedienelements
- 16: Symbolfeld
- 18: Trägerstruktur
- 20: Feder
- 22: Schalter
- 24: Schaltergehäuse
- 26: Schaltorgan
- 28: Stößel
- 30: Betätigungssensorik
- 32: Ansteuereinheit
- 34: Niederdrückkraftschwellen-Umschaltvorrichtung
- 36: an dem Bedienelement angeordnetes erstes Teil
- 38: an der Trägerstruktur angeordnetes zweites Teil
- 39: Weiterleitung des Schaltersignals
- 40: Permanent-Elektrohaftmagnet
- 42: Anker
- 44: Stator
- 46: (Luft-)Spalt
- 48: Spule
- 50: Permanentmagnet

### LITERATURVERZEICHNIS

DE-A-10 2011 089 400
DE-B-10 2014 019 041
DE-A-10 2010 026 910
DE-B-10 2018 212 618

## Patentansprüche

1. Bedieneinheit für ein Fahrzeug, mit
- einem Gehäuse (11),
- einem Bedienelement (12) mit einer Bedienoberfläche (14), die mehrere Symbolfelder (16) aufweist, welchen bei Betätigung des Bedienelements (12) auslösbare Bedienfunktionen zugeordnet sind,
- wobei das Bedienelement (12) rückstellfähig sowie mittels eines Betätigungsobjekts, insbesondere mittels des Fingers einer Hand, niederdrückbar an einer Trägerstruktur (18) angeordnet ist,
- einer ansteuerbaren Niederdrückkraftschwellen-Umschaltvorrichtung (34) zum Umschalten der zum Niederdrücken des Bedienelements (12) zu überwindenden Kraft zwischen einem ersten Schwellwert und einem im Vergleich zum ersten Schwellwert kleineren zweiten Schwellwert, und umgekehrt,
- einer Betätigungssensorik (30) zur Erkennung, ob das Betätigungsobjekt bei einer Betätigung des Bedienelements (12) dieses innerhalb eines der Symbolfelder (16) der Bedienoberfläche (14) kontaktiert, und
- einer Auswerte- und Ansteuereinheit (32), die von der Betätigungssensorik (30) oder unter anderem von der Betätigungssensorik (30) Signale empfängt und die Niederdrückkraftschwellen-Umschaltvorrichtung (34) oder unter anderem an die Niederdrücckraftschwellen-Umschaltvorrichtung(34) nur dann durch Veränderung ihrer Ansteuerung zum Umschalten von dem ersten Schwellwert auf den zweiten Schwellwert veranlasst, wenn sich bei einer Betätigung des Bedienelements (12) das Betätigungsobjekt innerhalb eines der Symbolfelder (16) in Kontakt mit der Bedienoberfläche (14) befindet,
**dadurch gekennzeichnet,**
- **dass** die Niederdrückkraftschwellen-Umschaltvorrichtung (34) mindestens einen Elektromagneten (40) mit einem Stator (44) und einem Anker (42), die relativ zueinander bewegbar sind, und eine Spule (48) aufweist und
- **dass** entweder der Anker (42) an dem Bedienelement (12) oder an einem mit dem Bedienelement (12) mechanisch verbundenen Element (36) an und/oder in dem Gehäuse (11) montiert ist, oder entweder der Stator (44) an dem Bedienelement (12) oder an einem mit dem Bedienelement (12) mechanisch verbundenen Element befestigt und der Anker (42) an/oder in dem Gehäuse (11) montiert ist.

2. Bedieneinheit nach Anspruch 1, **dadurch gekennzeichnet, dass** der Stator (44) des Elektromagnets (40) einen Permanentmagneten (50) zur Erzeugung eines Permanent-Magnetfeldes (50) zum Festhalten des Ankers (42) aufweist.

3. Bedieneinheit nach Anspruch 2, **dadurch gekennzeichnet, dass** die Spule (48) zum Umschalten auf den ersten Schwellwert und/oder zur Beibehaltung des ersten Schwellwerts von der Auswerte- und Ansteuereinheit (32) kein Ansteuersignal zum Bestromen der Spule (48) empfängt.

4. Bedieneinheit nach Anspruch 3, **dadurch gekennzeichnet, dass** die Spule (48) zum Umschalten auf den zweiten Schwellenwert und/oder zur Beibehaltung des zweiten Schwellenwertsein Ansteuersignal zum Bestromen der Spule (48) zwecks Reduktion oder Neutralisierung des Permanent-Magnetfeldes (50) empfängt.

5. Bedieneinheit nach einem der Ansprüche 1 bis 4, **dadurch gekennzeichnet, dass** mittels der Niederdrückkraftschwellen-Umschaltvorrichtung (34) bei nicht in Kontakt mit einem Symbolfeld (16) des Bedienelements (12) befindlichem Betätigungsobjekt der erste Schwellwert ausgewählt ist und dass dann, wenn die Betätigungssensorik (30) signalisiert, dass das Betätigungsobjekt die Bedienoberfläche (14) innerhalb eines der Symbolfelder (16) kontaktiert, die Auswerte- und Ansteuereinheit (32) an die Niederdrückkraftschwellen-Umschaltvorrichtung (34) ein Ansteuersignal zum Umschalten auf den zweiten Schwellwert ausgibt.

6. Bedieneinheit nach einem der Ansprüche 1 bis 5, **dadurch gekennzeichnet, dass** die Niederdrückkraftschwellen-Umschaltvorrichtung (34) bei nicht in Kontakt mit einem Symbolfeld (16) des Bedienelements (12) befindlichem Betätigungsobjekt der erste Schwellwert ausgewählt ist, oder dass mittels der Niederdrückkraftschwellen-Umschaltvorrichtung (34) bei nicht in Kontakt mit einem Symbolfeld (16) des Bedienelements (12) befindlichem Betätigungsobjekt der erste Schwellwert so lange ausgewählt ist, wie die Betätigungssensorik (30) keine Berührung eines Symbolfeldes (16) an der Bedienoberfläche (14) durch das Betätigungsobjekt signalisiert.

7. Bedieneinheit nach einem der Ansprüche 1 bis 6, **dadurch gekennzeichnet, dass** das Bedienelement (12) ein Display mit oder ohne Hinterleuchtung und mit einer veränderbare Information in Form z. B. von Symbolen, Icons, alphanumerischen Zeichen oder Graphiken anzeigende Anzeigefläche als Bedienoberfläche oder das Bedienelement eine unveränderbare Information, insbesondere hinterleuchtete Information in Form z. B. von Symbolen, Icons, alphanumerischen Zeichen oder Graphiken anzeigende Anzeigefläche als Bedienoberfläche (14) aufweist.

8. Bedieneinheit nach einem der Ansprüche 1 bis 7, **dadurch gekennzeichnet, dass** zumindest eines der Symbolfelder (16) zumindest temporär derart konfigurierbar ist, dass dann, wenn die Betätigungssensorik (30) eine Kontaktierung eines solchen Symbolfeldes (16) durch das Betätigungsobjekt signalisiert, die Auswerte- und Ansteuereinheit (32) an die Niederdrückkraftschwellen-Umschaltvorrichtung (34) kein Ansteuersignal zum Umschalten von dem ersten Schwellwert auf den zweiten Schwellwert ausgibt.

9. Bedieneinheit nach einem der Ansprüche 1 bis 8, **dadurch gekennzeichnet, dass** der zweite Schwellwert gleich der Kraft ist, die für das Niederdrücken des Bedienelements (12) bei einer Kontaktierung eines Symbolfeldes (16) des Bedienelements (12) durch das Betätigungsobjekt vorgesehen und damit aufzubringen ist.

10. Bedieneinheit nach einem der Ansprüche 1 bis 8, **dadurch gekennzeichnet, dass** der erste Schwellwert um mindestens eine Größenordnung größer ist als die Kraft, die für das Niederdrücken des Bedienelements (12) bei einer Kontaktierung eines Symbolfeldes (16) des Bedienelements (12) durch das Betätigungsobjekt aufzubringen ist.

11. Bedieneinheit nach Anspruch 10, **dadurch gekennzeichnet, dass** der zweite Schwellwert gleich der Kraft ist, die für das Niederdrücken des Bedienelements (12) bei einer Kontaktierung eines Symbolfeldes (16) des Bedienelements (12) durch das Betätigungsobjekt vorgesehen und damit aufzubringen ist.

## Claims

1. An operating unit for a vehicle comprising
- a housing (11),
- an operating element (12) having an operating interface (14) comprising a plurality of symbol fields (16) to which, when the operating element (12) is actuated, triggerable operating functions are assigned,
- wherein the operating element (12) is arranged at a support structure (18) in a condition as being resettable and being able to be pressed down by an actuation object, in particular by the finger of a hand,
- a controllable press-down force threshold switching device (34) for switching the force to be overcome for pressing down the operating element (12) between a first threshold value and a second threshold value which is smaller as compared to the first threshold value, and vice versa,
- an actuation sensor system (30) for detecting whether the actuation object, when actuating the operating element (12), comes into contact with the latter within one of the symbol fields (16) of the operating interface (14), and
- an evaluation and control unit (32) receiving signals from the actuation sensor system (30) or from the actuation sensor system (30), among others, and causing, by changing its control, the press-down force threshold switching device (34) or the press-down force threshold switching device (34), among others, to switch from the first threshold to the second threshold only when the actuation object within one of the symbol fields (16) is in contact with the operating interface (14) when the operating element (12) is actuated,
**characterized in that**
- the press-down force threshold switching device (34) comprises at least one electromagnet (40) having a stator (44) and an armature (42) which are movable relative to each other, and a coil (48), and
- either the armature (42) is mounted to the operating element (12) or to an element (36) mechanically connected to the operating element (12) at and/or in the housing (11), or the stator (44) is either mounted to the operating element (12) or to an element mechanically connected to the operating element (12), and the armature (42) is mounted to and/or in the housing (11).

2. The operating unit according to claim 1, **characterized in that** the stator (44) of the electromagnet (40) comprises a permanent magnet (50) for generating a permanent magnetic field (50) for holding the armature (42).

3. The operating unit according to claim 2, **characterized in that** the coil (48) does not receive, from the evaluation and control unit (32), a control signal for supplying current to the coil (48) for switching to the first threshold value and/or for maintaining the first threshold value.

4. The operating unit according to claim 3, **characterized in that** the coil (48) receives a control signal for supplying current to the coil (48) for switching to the second threshold value and/or for maintaining the second threshold value for the purpose of reducing or neutralizing the permanent magnetic field (50).

5. The operating unit according to any one of claims 1 to 4, **characterized in that**, when the actuation object is not in contact with a symbol field (16) of the operating element (12), the press-down threshold force switching device (34) selects the first threshold value, and that, when the actuation sensor system (30) signals that the actuation object contacts the operating interface (14) within one of the symbol fields (16), the evaluation and control unit (32) outputs a control signal for switching to the second threshold value to the press-down force threshold switching device (34).

6. The operating unit according to any one of claims 1 to 5, **characterized in that**, when the actuation object is not in contact with a symbol field (16) of the operating element (12), the press-down threshold force switching device (34) selects the first threshold value, or that, when the actuation object is not in contact with a symbol field (16) of the operating element (12), the press-down force threshold switching device (34) selects first threshold value as long as the actuation sensor system (30) does not signal that the actuation object touches a symbol field (16) on the operating interface (14).

7. The operating unit according to any one of claims 1 to 6, **characterized in that** the operating element (12) comprises a display with or without backlighting and having a display area as an operating interface displaying a changeable information in the form of e.g. symbols, icons, alphanumeric characters or graphics, or the operating element comprises a display area as an operating interface (14) displaying an unchangeable information, in particular a backlit information, in the form of e.g. symbols, icons, alphanumeric characters or graphics.

8. The operating unit according to any one of claims 1 to 7, **characterized in that** at least one of the symbol fields (16) is at least temporarily configurable such that, when the actuation sensor system (30) signals that the actuation object contacts such a symbol field (16), the evaluation and control unit (32) does not output a control signal to the press-down force threshold switching device (34) for switching from the first threshold value to the second threshold value.

9. The operating unit according to any one of claims 1 to 8, **characterized in that** the second threshold value is equal to the force provided and thus to be exerted for pressing down the operating element (12) when the actuation objects contacts a symbol field (16) of the operating element (12).

10. The operating unit according to any one of claims 1 to 8, **characterized in that** the first threshold value is at least by one magnitude larger than the force to be exerted for pressing down the operating element (12) when the actuation object contacts a symbol field (16) of the operating element (12).

11. The operating unit according to claim 10, **characterized in that** the second threshold value is equal to the force provided and thus to be exerted for pressing down the operating element (12) when the actuation objects contacts a symbol field (16) of the operating element (12).

## Revendications

1. Unité de commande pour un véhicule, dotée
- d'un boîtier (11),
- d'un élément de commande (12) doté d'une surface de commande (14) comportant plusieurs champs de symbole (16), auxquels sont associées des fonctions de commande déclenchables lors de l'actionnement de l'élément de commande (12),
- dans laquelle l'élément de commande (12) est disposé sur une structure porteuse (18) de manière élastiquement enfonçable au moyen d'un objet d'actionnement, en particulier au moyen d'un doigt d'une main,
- d'un dispositif de permutation de seuil de force d'enfoncement (34) contrôlable destiné à permuter la force à surpasser pour enfoncer l'élément de commande (12) entre une première valeur seuil et une deuxième valeur seuil inférieure en comparaison à la première valeur seuil, et inversement,
- d'un système de capteurs d'actionnement (30) destiné à reconnaître si l'objet d'actionnement entre en contact avec l'élément de commande (12), lors d'un actionnement de celui-ci, à l'intérieur d'un des champs de symbole (16) de la surface de commande (14), et
- d'une unité d'analyse et de contrôle (32), laquelle reçoit des signaux du système de capteurs d'actionnement (30) ou entre autres du système de capteurs d'actionnement (30) et ne permet en modifiant son contrôle au dispositif de permutation de seuil de force d'enfoncement (34) ou entre autres au dispositif de permutation de seuil de force d'enfoncement (34) de permuter de la première valeur seuil à la deuxième valeur seuil que si l'objet d'actionnement se trouve en contact avec la surface de commande (14) à l'intérieur d'un des champs de symbole (16) lors d'un actionnement de l'élément de commande (12),
**caractérisée**
- **en ce que** le dispositif de permutation de seuil de force d'enfoncement (34) comporte au moins un électroaimant (40) doté d'un stator (44) et d'une armature (42), lesquels sont mobiles l'un par rapport à l'autre, et une bobine (48) et
- **en ce que** l'armature (42) est montée soit sur l'élément de commande (12) soit sur un élément (36) relié mécaniquement à l'élément de commande (12), sur et/ou dans le boîtier (11), ou le stator (44) est fixé soit sur l'élément de commande (12) soit sur un élément relié mécaniquement à l'élément de commande (12) et l'armature (42) est montée sur et/ou dans le boîtier (11).

2. Unité de commande selon la revendication 1, **caractérisée en ce que** le stator (44) de l'électroaimant (40) comporte un aimant permanent (50) destiné à générer un champ magnétique permanent (50) afin de maintenir l'armature (42).

3. Unité de commande selon la revendication 2, **caractérisée en ce qu'**afin de permuter vers la première valeur seuil et/ou afin de maintenir la première valeur seuil, la bobine (48) ne reçoit pas de signal de contrôle d'alimentation de la bobine (48) depuis l'unité d'analyse et de contrôle (32).

4. Unité de commande selon la revendication 3, **caractérisée en ce qu'**afin de permuter vers la deuxième valeur seuil et/ou afin de maintenir la deuxième valeur seuil, la bobine (48) reçoit un signal de contrôle d'alimentation de la bobine (48) afin de réduire ou de neutraliser le champ magnétique permanent (50).

5. Unité de commande selon l'une des revendications 1 à 4, **caractérisée en ce que** la première valeur seuil est sélectionnée au moyen du dispositif de permutation de seuil de force d'enfoncement (34) lorsque l'objet d'actionnement ne se trouve pas en contact avec un champ de symbole (16) de l'élément de commande (12) et **en ce qu'**ensuite, si le système de capteurs d'actionnement (30) signale que l'objet d'actionnement entre en contact avec la surface de commande (14) à l'intérieur d'un des champs de symbole (16), l'unité d'analyse et de contrôle (32) émet vers le dispositif de permutation de seuil de force d'enfoncement (34) un signal de contrôle afin de permuter vers la deuxième valeur seuil.

6. Unité de commande selon l'une des revendications 1 à 5, **caractérisée en ce que** la première valeur seuil est sélectionnée au moyen du dispositif de permutation de seuil de force d'enfoncement (34) lorsque l'objet d'actionnement ne se trouve pas en contact avec un champ de symbole (16) de l'élément de commande (12), ou **en ce que** la première valeur seuil est sélectionnée au moyen du dispositif de permutation de seuil de force d'enfoncement (34) lorsque l'objet d'actionnement ne se trouve pas en contact avec un champ de symbole (16) de l'élément de commande (12), tant que le système de capteurs d'actionnement (30) ne signale pas de contact d'un champ de symbole (16) sur la surface de commande (14) par l'objet d'actionnement.

7. Unité de commande selon l'une des revendications 1 à 6, **caractérisée en ce que** l'élément de commande (12) comporte comme surface de commande un écran avec ou sans rétroéclairage et avec une information modifiable sous forme d'une surface d'affichage affichant par exemple, des symboles, des icônes, des signes alphanumériques ou des graphismes ou l'élément de commande comporte comme surface de commande (14) une information non modifiable, en particulier une information rétroéclairée, sous forme d'une surface d'affichage affichant par exemple, des symboles, des icônes, des signes alphanumériques ou des graphismes.

8. Unité de commande selon l'une des revendications 1 à 7, **caractérisée en ce qu'**au moins un des champs de symbole (16) est configurable au moins temporairement de telle sorte que lorsque le système de capteurs d'actionnement (30) signale un contact d'un tel champ de symbole (16) par l'objet d'actionnement, l'unité d'analyse et de contrôle (32) n'émet pas de signal de contrôle vers le dispositif de permutation de seuil de force d'enfoncement (34) pour permuter de la première valeur seuil à la deuxième valeur seuil.

9. Unité de commande selon l'une des revendications 1 à 8, **caractérisée en ce que** la deuxième valeur seuil est égale à la force prévue pour l'enfoncement de l'élément de commande (12) dans le cas où l'objet d'actionnement entre en contact avec un champ de symbole (16) de l'élément de commande (12) et devant donc être appliquée.

10. Unité de commande selon l'une des revendications 1 à 8, **caractérisée en ce que** la première valeur seuil est supérieure d'au moins un ordre de grandeur à la force devant être appliquée pour l'enfoncement de l'élément de commande (12) dans le cas où l'objet d'actionnement entre en contact avec un champ de symbole (16) de l'élément de commande (12).

11. Unité de commande selon la revendication 10, **caractérisée en ce que** la deuxième valeur seuil est égale à la force prévue pour l'enfoncement de l'élément de commande (12) dans le cas où l'objet d'actionnement entre en contact avec un champ de symbole (16) de l'élément de commande (12) et devant donc être appliquée.
